Europäisches Patentamt

(19) European Patent Office

Office européen des brevets

(11) Veröffentlichungsnummer: **0 011 801**
**B1**

(12) # EUROPÄISCHE PATENTSCHRIFT

(45) Veröffentlichungstag der Patentschrift:
26.05.82

(51) Int. Cl.³: **C 25 F 3/02**, C 23 F 1/00

(21) Anmeldenummer: **79104576.8**

(22) Anmeldetag: **19.11.79**

(54) **Verfahren zur elektrochemischen Bearbeitung metallischer Oberflächen.**

(30) Priorität: **22.11.78 DE 2850605**

(43) Veröffentlichungstag der Anmeldung:
**11.06.80 Patentblatt 80/12**

(45) Bekanntmachung des Hinweises auf die Patenterteilung:
**26.05.82 Patentblatt 82/21**

(84) Benannte Vertragsstaaten:
**AT BE CH FR GB IT NL**

(56) Entgegenhaltungen:
**DE-A-2 637 745**
**GB-A-1 151 943**
**US-A-3 271 282**

(73) Patentinhaber: **Kernforschungsanlage Jülich Gesellschaft mit beschränkter Haftung, Postfach 1913, D-5170 Jülich (DE)**

(84) Benannte Vertragsstaaten: **CH FR GB IT**

(73) Patentinhaber: **Faul, Wolfgang, Kopernikusstrasse 20, D-5170 Jülich (DE)**

(84) Benannte Vertragsstaaten: **BE NL AT**

(73) Patentinhaber: **Fürst, Leander, Gutenbergstrasse 22, D-5170 Jülich (DE)**

(84) Benannte Vertragsstaaten: **BE NL AT**

(73) Patentinhaber: **Kastening, Bertel, Prof. Dr., Lofotenstrasse 21, D-2000 Hamburg 73 (DE)**

(84) Benannte Vertragsstaaten: **BE NL AT**

(72) Erfinder: **Faul, Wolfgang, Kopernikusstrasse 20, D-5170 Jülich (DE)**
Erfinder: **Fürst, Leander, Gutenbergstrasse 22, D-5170 Jülich (DE)**
Erfinder: **Kastening, Bertel, Prof. Dr., Lofotenstrasse 21, D-2000 Hamburg 73 (DE)**

Verfahren zur elektrochemischen Bearbeitung metallischer Oberflächen

Die Erfindung bezieht sich auf ein Verfahren zur elektrochemischen Bearbeitung metallischer Oberflächen von berührungsfrei zu Kathode und Anode angeordneten Werkstücken mit einem Elektrolyten, der zur Übertragung elektrischer Ladung auf die zu bearbeitende Oberfläche im Elektrolyten suspendierte Graphit- oder Aktivkohlepulverteilchen enthält. Die Teilchen werden in einer Elektrolysezelle an deren Anode aufgeladen und vor einer Entladung an der Kathode der Elektrolysezelle durch ein die Kathode abschirmendes Diaphragma oder eine Ionenaustauschermembran geschützt.

Nach diesem Verfahren werden gedruckte Schaltungen hergestellt wobei von Kunststoffplatten, die ein- oder doppelseitig kupferkaschiert sind, nach Abdecken der die Schaltung bildenden Metallflächen mit einer Schutzschicht der übrige Teil der Kupferkaschierung abgetragen wird. Dabei werden die im Elektrolyten suspendierten, elektrisch leitfähigen Körper an der Anode einer Elektrolysezelle positiv aufgeladen und anschliessend zugleich mit dem Elektrolyten mit der Oberfläche der Kupferschicht in Berührung gebracht, wobei Metallionen in Lösung gehen, die an der Kathode der Elektrolysezelle wieder abgeschieden werden. Das Verfahren wird auch eingesetzt zur Herstellung metallischer Formteile, bei denen es auf hohe Präzision und Konturenschärfe ankommt, wie zum Beispiel bei strömungsführenden Teilen, wie Turbinenschaufeln oder Düsen, oder auch für die Ausbildung des Oberflächenreliefs von Druckplatten oder -walzen. Die nach diesem Verfahren mögliche unmittelbare Wiedergewinnung der abgetragenen Metalle, die sich an der Gegenelektrode abscheiden, führt zu einem wirtschaftlichen und gleichzeitig umweltfreundlichen Verfahren. Dieser Vorzug des Verfahrens wird insbesondere auch ausgenutzt bei der Rückgewinnung von Metallen aus sogenanntem Kabelschrott.

Für dieses in der DE-AS 2 150 748 und DE-PS 2 655 137 beschriebene Verfahren ist es bekannt, im Elektrolyten Graphit- oder Aktivkohlepulverteilchen zu suspendieren, die als leitfähige Körper den Transport der zur Abtragung der Metalle erforderlichen Ladung zwischen Anode und Oberfläche der zu bearbeitenden Werkstücke übernehmen. Die auf diese Weise übertragene Ladung ist von der Konzentration der im Elektrolyten suspendierten leitfähigen Körper abhängig. Die suspendierbare Teilchenmenge ist jedoch – soll der Elektrolyt noch ausreichend flüssig bleiben – nach oben hin begrenzt. Dies beeinträchtigt eine wünschenswerte Steigerung der Abtragungsgeschwindigkeit der zu behandelnden Oberfläche.

Aufgabe der Erfindung ist es daher, ein elektrochemisches Verfahren zu Bearbeitung metallischer Oberflächen zu schaffen, bei dem eine Beschleunigung der für die Abtragung der metallischen Oberfläche erforderlichen Bearbeitungszeit ohne wesentliche Beeinflussung der Viskosität des Elektrolyten ermöglicht wird.

Diese Aufgabe wird bei einem Verfahren der eingangs genannten Art gemäss der Erfindung durch die im Patentanspruch 1 angegebenen Massnahmen gelöst. Durch Zugabe von Vanadium(V)-Ionen zum Elektrolyten wird die metallische Oberfläche nicht nur elektrochemisch abgetragen, sondern auch chemisch geätzt. Vorteilhaft ist, dass die beim Ätzen der Metalloberfläche gebildeten Vanadium(IV)-Ionen an der Anode der Elektrolysezelle wieder zu Vanadium(V)-Ionen oxidierbar sind, so dass nach Bearbeitung der Oberfläche in die Elektrolysezelle zurückgeführter Elektrolyt auch hinsichtlich des für die Ätzung wirksamen Vanadiums wieder regeneriert wird.

Als Vanadiumverbindungen sind beispielsweise Vanadiumtrioxid oder Vanadylsulfat im Elektrolyten lösbar, die beide an der Anode der Elektrolysezelle fünfwertiges Vanadium bilden. Bevorzugt wird Vanadiumpentoxid verwendet. Eine vollständige Löslichkeit im Elektrolyten ergibt sich bis zu etwa 0,5 Mol Vanadiumpentoxid pro Liter Elektrolyt oder einer dementsprechenden Menge einer anderen Vanadiumverbindung.

Der Elektrolyt enthält in bekannter Weise wässrige Schwefelsäure, Ammoniak oder Ammoniumkarbonat. Die Konzentration der Graphit- oder Aktivkohlepulverteilchen je Liter Elektrolyt beträgt zwischen 50 bis 250 g Graphit- oder Aktivkohlepulver je nach gewünschter Viskosität des Elektrolyten. Wirtschaftlich optimal sind Konzentrationswerte zwischen 150 bis 200 g Graphit- oder Aktivkohlepulver je Liter Elektrolyt.

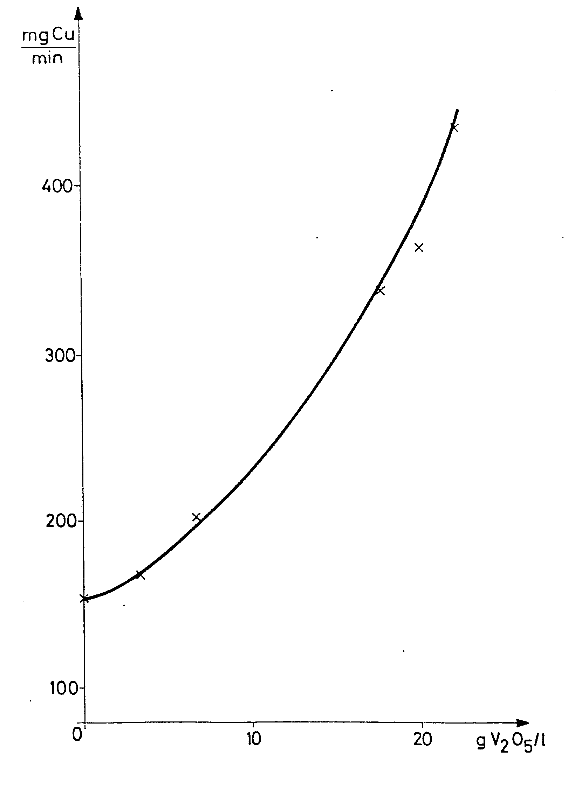

Die Erfindung wird anhand von Ausführungsbeispielen näher erläutert. In der Zeichnung ist ein Diagramm wiedergegeben, das in schematischer Darstellung die Steigerung der Abtragungsgeschwindigkeit durch Zugabe von Vanadium in den Elektrolyten verdeutlicht. Im Diagramm ist die Abhängigkeit des Abtrags von Kupfer von einer Kupferoberfläche in mgCu/min in Abhängigkeit vom Gehalt an Vanadiumpentoxid in der Lösung in g $V_2O_5$/l angegeben.

Ausführungsbeispiel 1

Es wurden in einen Elektrolyten, der 1 Mol Schwefelsäure pro Liter enthielt, Aktivkohlepulver in einer Konzentration von 15 Gew.-% suspendiert. Der auf 45 °C aufgeheizte Elektrolyt wurde mittels einer Flachstrahldüse auf eine Kupferplatte aufgesprüht. Der Gewichtsverlust der Kupferplatte pro Zeiteinheit wurde gemessen. Die erzielten Abtragungsgeschwindigkeiten in Abhängigkeit vom Vanadiumgehalt im Elektrolyten sind im Diagramm aufgetragen. Daraus ist ersichtlich, dass die Abtragungsgeschwindigkeit von Kupfer mit steigendem Vanadiumgehalt im Elektrolyten zunimmt. Die Abtragungsgeschwindigkeit erhöht sich von 160 mgCu/min bei einem Elektrolyten, der kein Vanadiumpentoxid enthielt, bis auf 434 mgCu/min bei einer Konzentration von Vanadiumpentoxid im Elektrolyten von 22 g $V_2O_5$/l.

Ausführungsbeispiel 2

In einen alkalischen Elektrolyten, der pro Liter 150 g Ammoniumkarbonat und 25 ml einer 25%igen wässrigen Ammoniaklösung sowie 15 Gew.-% Aktivkohlepulver in suspendierter Form enthielt, wurde Vanadiumpentoxid mit steigender Konzentration gelöst. Beim Abtragen einer Kupferplatte mit auf etwa 50 °C aufgeheiztem Elektrolyten wurde ohne Zusatz von Vanadiumpentoxid eine Abtragungsgeschwindigkeit von 104 mgCu/min erzielt. Nach Zugabe von 43 g $V_2O_5$ pro Liter Elektrolyt stieg die Abtragungsgeschwindigkeit bis auf 124 mgCu/min.

Eine Steigerung der Abtragungsgeschwindigkeit durch Zugabe von Vanadiumpentoxid wurde in gleicher Weise auch bei Elektrolyten mit Graphit- oder Aktivkohlepulverkonzentration im Bereich zwischen 50 und 250 g pro Liter Ätzlösung erreicht.

**Patentansprüche**

1. Verfahren zur elektrochemischen Bearbeitung metallischer Oberflächen von berührungsfrei zu Kathode und Anode angeordneten Werkstücken mit einem Elektrolyten, der zur Übertragung elektrischer Ladung auf die zu bearbeitende Oberfläche im Elektrolyten suspendierte Graphit- oder Aktivkohlepulverteilchen enthält, die in einer Elektrolysezelle an der Anode aufgeladen werden und vor einer Entladung an der Kathode der Elektrolysezelle durch ein in die Kathode abschirmendes Diaphragma oder eine Ionenaustauschermembran geschützt sind, dadurch gekennzeichnet, dass im Elektrolyten eine Verbindung des 5wertigen Vanadiums oder eine Vanadiumverbindung, die an der Anode der Elektrolysezelle Vanadium(V)-Ionen bildet, gelöst wird.

2. Verfahren nach Anspruch 1, dadurch gekennzeichnet, dass im Elektrolyten Vanadiumpentoxid gelöst wird.

3. Verfahren nach Anspruch 2, dadurch gekennzeichnet, dass eine bis zu etwa 0,5 Mol Vana167iumpentoxid pro Liter Elektrolyt entsprechende Menge einer Vanadiumverbindung im Elektrolyten gelöst wird.

**Claims**

1. Process for the electrochemical treatment of metallic surfaces of workpieces, arranged without contact with cathode or anode, with an electrolyte which, for the transfer of electric charge to the surface to be treated, contains particles of graphite or activated carbon powder, which are suspended in the electrolyte and which are charged at the anode in an electrolytic cell and are protected from discharge at the cathode of the electrolytic cell by a diaphragm which screens the cathode or by an ion exchanger membrane, characterised in that a compound of 5-valent vanadium, or a vanadium compound which forms vanadium(V)-ions at the anode of the electrolytic cell, is dissolved in the electrolyte.

2. Process according to Claim 1, characterised in that vanadium pentoxide is dissolved in the electrolyte.

3. Process according to Claim 2, characterised in that a quantity, corresponding to one equivalent up to about 0,5 mol of vanadium pentoxide per litre of electrolyte, of a vanadium compound is dissolved in the electrolyte.

**Revendications**

1. Procédé de traitement électrochimique de surfaces métalliques de pièces, qui sont disposées de manière à ne toucher ni la cathode, ni l'anode, à l'aide d'un électrolyte, qui contient pour le transfert de la charge électrique sur les surfaces à traiter des particules de poudre de graphite ou de charbon actif, qui sont en suspension dans l'électrolyte, qui sont chargées à l'anode d'une cellule d'électrolyse et qui sont empêchées de se décharger à la cathode de la cellule d'électrolyse par un diaphragme ou par une membrane échangeuse d'ions, protégeant la cathode, caractérisé en ce qu'il consiste à dissoudre dans l'électrolyte un composé du vanadium pentavalent ou un composé du vanadium qui forme des ions vanadium(V) à l'anode de la cellule d'électrolyse.

2. Procédé suivant la revendication 1, caractérisé en ce qu'il consiste à dissoudre de l'anhydride vanadique dans l'électrolyte.

3. Procédé suivant la revendication 2, aractérisé en ce qu'il consiste â dissoudre dans l'électrolyte une quantité d'un composé du vanadium allant de 1 équivalent jusqu'à 0,5 mole environ d'anhydride vanadique par litre d'électrolyte.